(19) Europäisches Patentamt / European Patent Office / Office européen des brevets

(11) **EP 4 614 794 A1**

(12) **EUROPEAN PATENT APPLICATION**

(43) Date of publication:
**10.09.2025 Bulletin 2025/37**

(21) Application number: **24161920.4**

(22) Date of filing: **07.03.2024**

(51) International Patent Classification (IPC):
$H02M\ 7/5387^{(2007.01)}$    $H02M\ 7/5395^{(2006.01)}$
$H02M\ 1/00^{(2006.01)}$    $H02M\ 1/32^{(2007.01)}$
$G01R\ 19/165^{(2006.01)}$

(52) Cooperative Patent Classification (CPC):
**H02M 7/5387; H02M 1/0012; H02M 1/0016;
H02M 1/0019; H02M 1/0022; H02M 1/0025;
H02M 1/32; H02M 7/5395;** G01R 19/16538

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Hitachi Energy Ltd
8050 Zürich (CH)**

(72) Inventors:
- **HUANG, Xing
  Beijing 100024 (CN)**
- **TAYYEBI, Ali
  72359 Västerås (SE)**

(74) Representative: **Vossius & Partner
Patentanwälte Rechtsanwälte mbB
Siebertstrasse 3
81675 München (DE)**

(54) **METHOD FOR CONTROLLING A POWER CONVERTER, POWER CONVERTER, CONTROLLER, MEDIUM AND COMPUTER PROGRAM PRODUCT**

(57)    A power converter, a method for controlling a power converter, a controller for a power converter, a computer-readable storage medium and a computer program product are provided. The method comprises: obtaining a first signal set; performing a first signal transformation to generate a first intermediate signal, comprising: generating a second signal set based on the first signal set; performing a Clarke transformation on the first signal set and the second signal set to generate a first transformed set and a second transformed set; extracting positive-sequence components and negative-sequence components; performing a first Park transformation on the positive-sequence components to generate positive-sequence components, and performing a second Park transformation on the negative-sequence components to generate negative-sequence components; and performing the first Park transformation on the first zero-sequence component and the second zero-sequence component to generate zero-sequence components; and controlling the power converter according to the first intermediate signal.

Fig. 1

**Description**

**TECHNICAL FIELD**

The present disclosure relates to a method for controlling a power converter, a power converter, a controller for a power converter, a computer-readable storage medium and a computer program product.

**BACKGROUND**

Currently, the power grid has been transformed into a so-called converter-dominated state, wherein the power converters are widely used to interface multiple types of energy sources (especially the renewable energy sources) and loads to the grid. Due their importance as the interface of the gird, the robustness of the power converters is expected in various conditions.

The method described in this section is not necessarily a method that has been previously conceived or employed. It should not be assumed that any of the methods described in this section is considered to be the prior art just because they are included in this section, unless otherwise indicated expressly. Similarly, the problem mentioned in this section should not be considered to be universally recognized in any prior art, unless otherwise indicated expressly.

**SUMMARY**

The present disclosure provides a power converter, a method for controlling a power converter, a controller for a power converter, a computer-readable storage medium and a computer program product.

According to an aspect of the present disclosure, a method for controlling a power converter is provided, wherein the method comprises: obtaining a first signal set comprising three-phases electrical signals at a port of the power converter; performing a first signal transformation on the first signal set to generate at least one first intermediate signal, comprising: generating a second signal set based on the first signal set, wherein a time shift between a signal of the first signal set and its corresponding signal of the second signal set is substantially T/4 or (-T/4), wherein T is a cycle of the three-phases electrical signals of the first signal set; performing a Clarke transformation on the first signal set and the second signal set respectively to generate a first transformed set and a second transformed set, wherein the first transformed set comprises a first $\alpha$-axis component, a first $\beta$-axis component and a first zero-sequence component, and the second transformed set comprises a second $\alpha$-axis component, a second $\beta$-axis component and a second zero-sequence component; extracting positive-sequence components and negative-sequence components of the first transformed set based on the first $\alpha$-axis component, the first $\beta$-axis component, the second $\alpha$-axis component and the second $\beta$-axis component, wherein the positive-sequence components of the first transformed set comprise a positive-sequence component of the first $\alpha$-axis component and a positive-sequence component of the first $\beta$-axis component, and the negative-sequence components of the first transformed set comprises a negative-sequence component of the first $\alpha$-axis component and a negative-sequence component of the first $\beta$-axis component; performing a first Park transformation on the positive-sequence components to generate a positive-sequence d-axis component and a positive-sequence q-axis component, and performing a second Park transformation on the negative-sequence components to generate a negative-sequence d-axis component and a negative-sequence q-axis component, wherein an angle of the first Park transformation is the angle of the three-phases electrical signals of the first signal set, and an angle of the second Park transformation is a negative value of the angle of the first Park transformation; and performing the first Park transformation on the first zero-sequence component and the second zero-sequence component to generate a zero-sequence d-axis component and a zero-sequence q-axis component, wherein the at least one first intermediate signal comprises at least one of the positive-sequence d-axis component, the positive-sequence q-axis component, the negative-sequence d-axis component, the negative-sequence q-axis component, the zero-sequence d-axis component and the zero-sequence q-axis component; and controlling the power converter according to the at least one first intermediate signal. According to some embodiments, a generalized dq0 transformation of three-phases electrical signals of the converter is provided, which can be applied to the imbalanced three-phases system and further improves the control accuracy and robustness of the power converter.

According to some embodiments, the three-phases electrical signals of the first signal set are three-phases phase voltage, three-phases line voltage, three-phases phase current or three-phases line current. According to some embodiments, the above-mentioned generalized dq0 transformation can be applied to different types of electrical signals.

According to some embodiments, the generating a second signal set based on the first signal set comprises: setting the second signal set according to historical data of the first signal set, wherein the historical data of the first signal set is the data sampled before T/4 in case that the time shift between one signal of the first signal set and the corresponding signal of the second signal set is T/4, and wherein the historical data of the first signal set is the data sampled before 3T/4 in case that the time shift between one signal of the first signal set and the corresponding signal of the second signal set is (-T/4). According to some embodiments, the second signal set is constructed based on the historical data of the obtained first signal set.

According to some embodiments, the generating a second signal set based on the first signal set comprises: setting the second signal set according to currently obtained data of the first signal set. According to some embodiments, the second signal set is constructed based on the currently obtained first signal set.

According to some embodiments, wherein the controlling the power converter according to the at least one first intermediate signal comprises: generating a control signal for the converter based on the at least one first intermediate signal by a control loop of the power converter, wherein the control loop comprises at least one of a PLL loop, an active power control loop, a reactive power control loop, a virtual impedance loop, a virtual admittance loop, a current control loop and a voltage control loop; and controlling the converter according to the generated control signal. According to some embodiments, the above-mentioned generalized dq0 transformation can be applied to different applications in the control of power converter.

According to some embodiments, the control loop comprises a PLL loop, wherein the PLL loop comprises a PI module and an integration module connected in series, and, the control signal comprises an angle signal, the generating a control signal for the converter based on the at least one first intermediate signal by a control loop of the power converter comprises: inputting to the at least one first intermediate signal into the PI module; and generating the angle signal at the output of the integration module, wherein the angle of the first Park transformation and the second Park transformation is determined based on the angle signal. According to some embodiments, as the generalized dq0 transformation is used in the PLL loop, the PLL loop does not rely on lowpass filtering, averaging methods, or approximate cancellation techniques that are conventionally used for the three phases imbalance, and it can achieve faster synchronization timescales.

According to some embodiments, the control loop comprises a non-PLL loop, and the generating a control signal for the converter based on the at least one first intermediate signal by a control loop of the power converter comprises: determining an error signal based on the at least one first intermediate signal and a reference signal; and generating the control signal based on the error signal. According to some embodiments, as the generalized dq0 transformation is used in the non-PLL loop, the intermediate signal irrelevant to the time can be provided, which simplifies the corresponding control mechanism.

According to some embodiments, the controlling the power converter according to the at least one first intermediate signal comprises: generating an angle signal based on the at least one first intermediate signal by a PLL loop of the power converter; generating at least one second intermediate signal based on the angle signal by a non-PLL loop of the power converter, wherein a second signal transformation different from the first signal transformation is used in the non-PLL loop; and controlling the power converter according to the at least one second intermediate signal. According to some embodiments, as the generalized dq0 transformation is used in the PLL loop, and the different signal transformation is used in at least one non-PLL loop, a flexible control structure can be provided.

According to some embodiments, the controlling the power converter according to the at least one first intermediate signal comprises: generating an angle signal by a PLL loop of the power converter, wherein a second signal transformation different from the first signal transformation is used in the PLL loop; inputting the angle signal and the at least one first intermediate signal into a non-PLL loop of the power converter to generate at least one second intermediate signal; and controlling the power converter according to the at least one second intermediate signal. According to some embodiments, as the generalized dq0 transformation is used in at least one non-PLL loop, and the different signal transformation is used in the PLL loop, a flexible control structure can be provided.

According to some embodiments, the power converter comprises at least one power switch and/or protection device, and the controlling the power converter according to the at least one first intermediate signal comprises: controlling the at least one power switch and/or protection device according to the at least one first intermediate signal. According to some embodiments, different components of the power converter can be controlled based on the intermediate signal.

According to some embodiments, the three-phases electrical signals of the first signal set are magnitude-imbalanced and/or phase-imbalanced. According to some embodiments, the method described in the present disclosure can be applied to different situations of three-phases imbalance.

According to another aspect of the present disclosure, a controller for a power converter is provided, wherein the controller is configured to perform any of claims described in the present disclosure.

According to yet another aspect of the present disclosure, a power converter is provided, wherein the power converter comprises: at least one power switch and/or at least one protection device; and the controller described in the present disclosure.

According to yet another aspect of the present disclosure, a computer-readable storage medium is provided, wherein the computer-readable storage medium has computer-readable instructions stored thereon, and when the computer-readable instructions are executed by a processor, the processor performs any of claims described in the present disclosure.

According to yet another aspect of the present disclosure, a computer program product is provided, which, when

EP 4 614 794 A1

executed by a computer, cause the computer to perform any of claims described in the present disclosure.

The technical effects of the method discussed above can be applied to the converter, the controller, the computer-readable storage medium and the computer program product, and are therefore omitted herein.

It should be understood that the content described in this section is not intended to identify critical or important features of the embodiments of the present disclosure, and is not used to limit the scope of the present disclosure either. Other features of the present disclosure will be easily understood through the following specification.

BRIEF DESCRIPTION OF THE DRAWINGS

The drawings exemplarily show embodiments and form a part of the specification, and are used to illustrate example implementations of the embodiments together with a written description of the specification. The embodiments shown are merely for illustrative purposes and do not limit the scope of the claims. Throughout the drawings, like reference signs denote like but not necessarily identical elements.

Fig. 1 is a schematic diagram illustrating a power converter according to some embodiments of the present disclosure;
Fig. 2 is a flow chart illustrating the method for controlling a power converter according to some embodiments of the present disclosure;
Fig. 3 is a flow chart illustrating the procedure of performing a first signal transformation on the first signal set to generate at least one first intermediate signal in Fig.2 according to some embodiments of the present disclosure;
Fig. 4A-4C are schematic diagram illustrating the controller for the power converter according to some embodiments of the present disclosure.
Fig. 5 is a schematic diagram illustrating a PLL loop of the controller for the power converter in Figs. 4A-4C according to some embodiments of the present disclosure;
Figs. 6A-6B are schematic diagrams illustrating a non-PLL loop of the controller for the power converter in Figs. 4A-4C according to some embodiments of the present disclosure; and
Fig. 7 is a schematic diagram illustrating a computing device that can be used in accordance with the methods disclosed herein.

DETAILED DESCRIPTION OF THE EMBODIMENTS

The present disclosure will be further described in detail below with reference to the drawings and embodiments. It can be understood that embodiments described herein are used merely to explain a related disclosure, rather than limit the disclosure. It should be additionally noted that, for ease of description, only parts related to the related disclosure are shown in the drawings.

It should be noted that the embodiments in the present disclosure and features in the embodiments can be combined with each other without conflict. If the number of elements is not specifically defined, there may be one or more elements, unless otherwise expressly indicated in the context. In addition, numbers of steps or functional modules used in the present disclosure are used merely to identify the steps or functional modules, rather than limit either a sequence of performing the steps or a connection relationship between the functional modules. As used herein, the term "and/or" includes any and all combinations of one or more of the associated listed items. The term "based on" is to be construed as "based at least in part on".

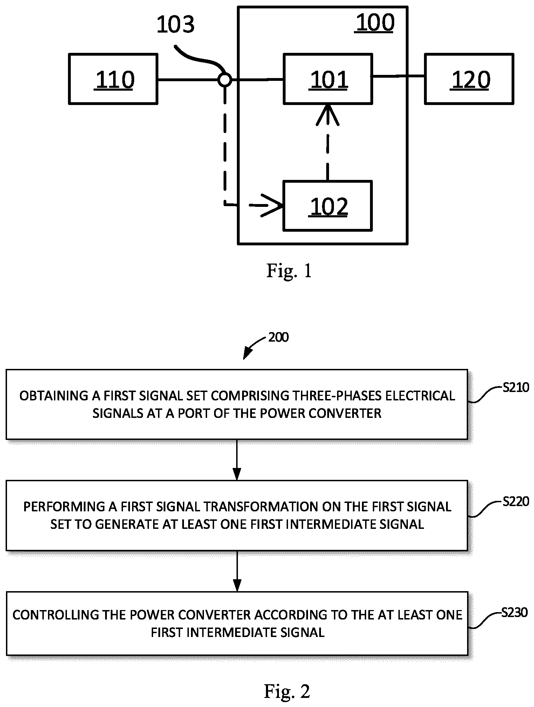

Fig. 1 is a schematic diagram illustrating a power converter 100 according to some embodiments of the present disclosure.

As shown in Fig. 1, the power converter 100 is coupled to the three-phases source/load 110 at one three-phases port, wherein the power converter 100 includes a controller 102 for obtaining the three-phases electrical signals at the three-phases port and control the power converter 100 based on the obtained three-phases electrical signals, for example, controlling at least power switch and/or at least one protection device of the power converter 100.

According to some embodiments, the power converter 100 includes a power electronics circuit 101 and a controller 102, wherein the power electronics circuit 101 include at least one power switch and/or at least one protection device, and the power electronics circuit 101 are couple to the three-phases source/load 110 at one three-phases port 103. Please noted that Fig. 1 has been simplified for the purpose of illustration, and the connection between the three-phases source/load 110 and the power electronics circuit 101 are three electrical lines corresponding to three phases.

According to some embodiments, in addition to the three-phases electrical signals, the power converter 100 is also coupled to a load/source 120 at another port, wherein the load/source 120 is the load when the three-phases source/load 110 is the three-phases source, and the load/source 120 is the source when the three-phases source/load 110 is the three-phases load.

According to some embodiments, the another port coupled to the load/source 120 can be a DC port or a AC port (for example, the three-phases port).

4

Currently, in the power system, the three-phase imbalance often occurs, resulting the negative-sequence and zero-sequence components of the electrical signals of the system. In order to ensure reliable power supply, the power converter is expected to operate normally under the three-phase imbalance. However, the conventional control for the power converter is usually designed under the assumption of three-phase balance, wherein the three-phase electrical signals only include positive-sequence components, and cannot be applied to the situation of three-phase imbalance.

At least to solve the above problems, the present disclosure provides a method for controlling a power converter, wherein the method comprises: obtaining a first signal set comprising three-phases electrical signals at a port of the power converter; performing a first signal transformation on the first signal set to generate at least one first intermediate signal, comprising: generating a second signal set based on the first signal set, wherein a time shift between a signal of the first signal set and its corresponding signal of the second signal set is substantially T/4 or (-T/4), wherein T is a cycle of the three-phases electrical signals of the first signal set; performing a Clarke transformation on the first signal set and the second signal set respectively to generate a first transformed set and a second transformed set, wherein the first transformed set comprises a first α-axis component, a first β-axis component and a first zero-sequence component, and the second transformed set comprises a second α-axis component, a second β-axis component and a second zero-sequence component; extracting positive-sequence components and negative-sequence components of the first transformed set based on the first α-axis component, the first β-axis component, the second α-axis component and the second β-axis component, wherein the positive-sequence components of the first transformed set comprise a positive-sequence component of the first α-axis component and a positive-sequence component of the first β-axis component, and the negative-sequence components of the first transformed set comprises a negative-sequence component of the first α-axis component and a negative-sequence component of the first β-axis component; performing a first Park transformation on the positive-sequence components to generate a positive-sequence d-axis component and a positive-sequence q-axis component, and performing a second Park transformation on the negative-sequence components to generate a negative-sequence d-axis component and a negative-sequence q-axis component, wherein an angle of the first Park transformation is the angle of the three-phases electrical signals of the first signal set, and an angle of the second Park transformation is a negative value of the angle of the first Park transformation; and performing the first Park transformation on the first zero-sequence component and the second zero-sequence component to generate a zero-sequence d-axis component and a zero-sequence q-axis component, wherein the at least one first intermediate signal comprises at least one of the positive-sequence d-axis component, the positive-sequence q-axis component, the negative-sequence d-axis component, the negative-sequence q-axis component, the zero-sequence d-axis component and the zero-sequence q-axis component; and controlling the power converter according to the at least one first intermediate signal.

According to some embodiments, a generalized dq0 transformation of full six-dimension signal representation is provided, wherein each of the components of the signal representation (i.e., the positive-sequence d-axis component, the positive-sequence q-axis component, the negative-sequence d-axis component, the negative-sequence q-axis component, the zero-sequence d-axis component and the zero-sequence q-axis component) is a time-invariant value in all kinds of situation including the three-phases imbalance. As the result, the performance of the power converter is improved, especially the control accuracy and robustness of the power converter.

According to some embodiments, the "Clarke transformation" refers to the transformation that transforms the three-phases signals into two-phases signals corresponds to two stationary axes orthogonal to each other.

According to some embodiments, the "α-axis" refers to the direct axis of the two stationary axes, and the "β-axis" refers to the quadrature axis of the two stationary axes. According to some embodiments, the "α-axis component" refers to the component mapped to the α-axis, and the "β-axis component" refers to the component mapped to the β-axis.

According to some embodiments, the Clarke transformation can be defined as follows:

$$\begin{bmatrix} s_\alpha \\ s_\beta \\ s_0 \end{bmatrix} = T_{Clarke} \begin{bmatrix} s_a \\ s_b \\ s_c \end{bmatrix},$$

wherein $s_a$, $s_b$ and $s_c$ are the signals of phase a, b and c, $s_\alpha$ is the α-axis component, $s_\beta$ is the β-axis component and $s_0$ is the zero-sequence component, and $T_{Clarke}$ is the matrix of the Clarke transformation.

According to some embodiments, the matrix $T_{Clarke}$ can be defined as follows:

$$T_{Clarke} = \frac{2}{3} \begin{bmatrix} 1 & -\frac{1}{2} & -\frac{1}{2} \\ 0 & \frac{\sqrt{3}}{2} & -\frac{\sqrt{3}}{2} \\ \frac{1}{2} & \frac{1}{2} & \frac{1}{2} \end{bmatrix}.$$

According to some embodiments, the "positive-sequence" refers to a balanced three-phase system with the phase sequence of "phase a - phase b - phase c", wherein the phase a leads the phase b by 120 degrees, the phase b leads the phase c by 120 degrees, and the phase C leads the phase a by 120 degrees.

According to some embodiments, the "negative-sequence" refers to a balanced three-phase system with the phase sequence of "phase a - phase c - phase b", wherein the phase a lags the phase b by 120 degrees, the phase b lags the phase c by 120 degrees, and the phase C lags the phase a by 120 degrees.

According to some embodiments, the "zero-sequence" refers to three phasors that are equal in magnitude and phase.

According to some embodiments, the "positive-sequence component" refers to the components of the signals that are in positive-sequence, the "negative-sequence component" refers to the components of the signals that are in negative-sequence, and the "zero-sequence component" refers to the components of the signals that are in zero-sequence.

According to some embodiments, the "Park transformation" refers to the transformation that transforms the two-phases signals corresponds to two stationary axes orthogonal to each other (i.e., the α-axis component and the β-axis component) into two rotary axes orthogonal to each other.

According to some embodiments, the "d-axis" refers to the direct axis of the two rotary axes, and the "q-axis" refers to the quadrature axis of the two rotary axes. According to some embodiments, the "d-axis component" refers to the component mapped to the d-axis, and the "q-axis component" refers to the component mapped to the q-axis.

According to some embodiments, the "angle of Park transformation" refers to the rotation angle of the d-axis.

According to some embodiments, the Park transformation can be defined as follows:

$$\begin{bmatrix} s_d \\ s_q \end{bmatrix} = T_{Park} \begin{bmatrix} s_\alpha \\ s_\beta \end{bmatrix},$$

wherein $s_\alpha$ is the α-axis component, $s_\beta$ is the β-axis component, $s_d$ is the d-axis component, $s_q$ is the q-axis component, and $T_{Park}$ is the matrix of the Park transformation.

According to some embodiments, the matrix $T_{Park}$ can be defined as follows:

$$T_{Park}(\theta) = \begin{bmatrix} \cos(\theta) & \sin(\theta) \\ -\sin(\theta) & \cos(\theta) \end{bmatrix},$$

wherein θ is the angle of the Park transformation.

Fig. 2 is a flow chart illustrating the method for controlling a power converter 200 according to some embodiments of the present disclosure. According to some embodiments, the method 200 can be used to operate the power converter in the present disclosure (for example, the power converter100 in Fig. 1).

As shown in Fig. 2, the method 200 comprises:

Step S210: obtaining a first signal set comprising three-phases electrical signals at a port of the power converter;
Step S220: performing a first signal transformation on the first signal set to generate at least one first intermediate signal; and
Step S230: controlling the power converter according to the at least one first intermediate signal.

According to some embodiments, the three-phases electrical signals of the first signal set can be sampled at the three-phases port of the power converter (for example, the port 103 in Fig. 1) by the corresponding sensor (for example, the voltage sensor or the current sensor).

According to some embodiments, the "three-phases signals" refers to the signals of the three phases at the same sampling point that correspond to the same electrical parameter. According to some embodiments, the "three-phases signals" are three sinusoidal waveform signals, each having the same frequency. For the purpose of illustration, the three-phases signals are usually denoted as phases a, b and c.

For example, the first signal set comprising the three-phases electrical signals can be denoted as

$$x_{abc}(t) = \begin{bmatrix} x_a(t) \\ x_b(t) \\ x_c(t) \end{bmatrix}$$, wherein $x_{abc}(t)$ is the first signal set, and $x_a(t)$, $x_b(t)$ and $x_c(t)$ are signals of phases a, b and c.

According to some embodiments, the three-phases electrical signals of the first signal set are three-phases phase voltage, three-phases line voltage, three-phases phase current or three-phases line current. According to some embodiments, the above-mentioned generalized dq0 transformation can be applied to different types of electrical signals.

According to some embodiments, the at least one first intermediate signal comprises at least one of the positive-sequence d-axis component, the positive-sequence q-axis component, the negative-sequence d-axis component, the negative-sequence q-axis component, the zero-sequence d-axis component and the zero-sequence q-axis component.

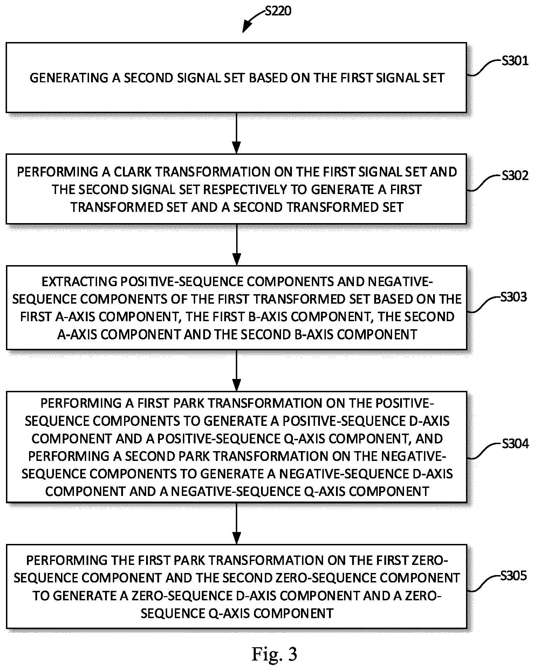

Fig. 3 is a flow chart illustrating the procedure of performing a first signal transformation on the first signal set to generate at least one first intermediate signal in Fig.2 (for example, S220) according to some embodiments of the present disclosure.

As shown in Fig. 3, Step S220 comprises:

Step S301: generating a second signal set based on the first signal set, wherein a time shift between a signal of the first signal set and its corresponding signal of the second signal set is substantially T/4 or (-T/4), wherein T is a cycle of the three-phases electrical signals of the first signal set;

Step S302: performing a Clarke transformation on the first signal set and the second signal set respectively to generate a first transformed set and a second transformed set, wherein the first transformed set comprises a first $\alpha$-axis component, a first $\beta$-axis component and a first zero-sequence component, and the second transformed set comprises a second $\alpha$-axis component, a second $\beta$-axis component and a second zero-sequence component;

Step S303: extracting positive-sequence components and negative-sequence components of the first transformed set based on the first $\alpha$-axis component, the first $\beta$-axis component, the second $\alpha$-axis component and the second $\beta$-axis component, wherein the positive-sequence components of the first transformed set comprise a positive-sequence component of the first $\alpha$-axis component and a positive-sequence component of the first $\beta$-axis component, and the negative-sequence components of the first transformed set comprises a negative-sequence component of the first $\alpha$-axis component and a negative-sequence component of the first $\beta$-axis component;

Step S304: performing a first Park transformation on the positive-sequence components to generate a positive-sequence d-axis component and a positive-sequence q-axis component, and performing a second Park transformation on the negative-sequence components to generate a negative-sequence d-axis component and a negative-sequence q-axis component, wherein an angle of the first Park transformation is the angle of the three-phases electrical signals of the first signal set, and an angle of the second Park transformation is a negative value of the angle of the first Park transformation; and

Step S305: performing the first Park transformation on the first zero-sequence component and the second zero-sequence component to generate a zero-sequence d-axis component and a zero-sequence q-axis component.

According to some embodiments, the second signal set also includes three signals, wherein the time shift between a signal of the first signal set and its corresponding signal of the second signal set is T/4 or (-T/4).

For example, when the time shift between one signal of the first signal set and the corresponding signal of the second signal set is T/4, the second signal set can be denoted as:

$$x_{abc}(t - T/4) = \begin{bmatrix} x_a(t - T/4) \\ x_b(t - T/4) \\ x_c(t - T/4) \end{bmatrix},$$

wherein $x_{abc}(t - T/4)$ is the second signal set, and $x_a(t - T/4)$, $x_b(t - T/4)$ and $x_c(t - T/4)$ are signals corresponding to the signals of phases a, b and c.

For example, when the time shift between one signal of the first signal set and the corresponding signal of the second signal set is (-T/4), the second signal set can be denoted as:

$$x_{abc}(t + T/4) = \begin{bmatrix} x_a(t + T/4) \\ x_b(t + T/4) \\ x_c(t - T/4) \end{bmatrix},$$

wherein $x_{abc}(t + T/4)$ is the second signal set, and $x_a(t + T/4)$, $x_b(t + T/4)$ and $x_c(t + T/4)$ are signals corresponding to the signals of phases a, b and c.

According to some embodiments, the generating a second signal set based on the first signal set (for example, step S301 in Fig. 3) comprises: setting the second signal set according to historical data of the first signal set, wherein the historical data of the first signal set is the data sampled before T/4 in case that the time shift between one signal of the first signal set and the corresponding signal of the second signal set is T/4, and wherein the historical data of the first signal set is the data sampled before 3T/4 in case that the time shift between one signal of the first signal set and the corresponding signal of the second signal set is (-T/4). According to some embodiments, the second signal set is constructed based on the historical data of the obtained first signal set, which can be used to extract positive-sequence components and negative-sequence components of the first signal set in the later step (for example, step S303 in Fig. 3).

According to some embodiments, the generating a second signal set based on the first signal set comprises: setting the second signal set according to currently obtained data of the first signal set. According to some embodiments, the second signal set is constructed based on the currently obtained first signal set, which can be used to extract positive-sequence components and negative-sequence components of the first signal set (for example, step S303 in Fig. 3).

According to some embodiments, the second signal set can be constructed by integration or derivation and straightforward signal-processing computations.

According to some embodiments, the first signal set and the second signal set can be constructed as a whole signal set. For example, the whole signal set $\underline{x}_{abc}(t)$ can be denoted as:

$$\underline{x}_{abc}(t) = \begin{bmatrix} x_{abc}(t) \\ x_{abc}(t-\tau) \end{bmatrix},$$

wherein $x_{abc}(t)$ and $x_{abc}(t-\tau)$ are the first signal set and the second signal set, wherein $\tau$ is the time shift between the first signal set and the second signal set.

According to some embodiments, as the first transformed set and a second transformed set are generated by performing a Clarke transformation on the first signal set and the second signal set respectively, the first $\alpha$-axis component is the $\alpha$-axis component of the three-phases signals of the first signal set, the first $\beta$-axis component is the $\beta$-axis component of the three-phases signals of the first signal set, the first zero-sequence component is the zero sequence component of the three-phases signals of the first signal set, the second $\alpha$-axis component is the $\alpha$-axis component of the three signals of the second signal set, the second $\beta$-axis component is the $\beta$-axis component of the three signals of the second signal set, and the second zero-sequence component is the zero sequence component of the three signals of the second signal set.

According to some embodiments, the performing a Clarke transformation on the first signal set and the second signal set respectively to generate a first transformed set and a second transformed set (for example, step S302 in Fig. 3) can be performed by multiplying the whole signal set $\underline{x}_{abc}(t)$ with a first transformation matrix $T_1$ to generate a second whole signal set $\underline{x}_{\alpha\beta0}(t)$. For example, $T_1$ can be denoted as:

$$T_1 = \begin{bmatrix} T_{Clarke} & 0_{3\times3} \\ 0_{3\times3} & T_{Clarke} \end{bmatrix},$$

the second whole signal set $\underline{x}_{\alpha\beta0}(t)$ can be denoted as:

$$\underline{x}_{\alpha\beta0}(t) = \begin{bmatrix} x_\alpha(t) \\ x_\beta(t) \\ x_0(t) \\ x_\alpha(t-\tau) \\ x_\beta(t-\tau) \\ x_0(t-\tau) \end{bmatrix},$$

and

$x_\alpha(t)$ is the first $\alpha$-axis component, $x_\beta(t)$ is the first $\beta$-axis component, $x_0(t)$ is first zero-sequence component, $x_\alpha(t-\tau)$ is the second $\alpha$-axis component, $x_\beta(t-\tau)$ is the second $\beta$-axis component, and $x_0(t-\tau)$ is the second zero-sequence component.

According to some embodiments, extracting positive-sequence components and negative-sequence components of the first transformed set based on the first $\alpha$-axis component, the first $\beta$-axis component, the second $\alpha$-axis component and the second $\beta$-axis component (for example, step S303 in Fig. 3) can be performed by multiplying the second whole signal set $\underline{x}_{\alpha\beta0}(t)$ with a second transformation matrix $T_2$ to generate a third whole signal set $\underline{x}_{+-0}(t)$. For example, $T_2$ can be denoted as:

$$T_2 = \frac{1}{2} \begin{bmatrix} 1 & 0 & 0 & 0 & -1 & 0 \\ 0 & 1 & 0 & 1 & 0 & 0 \\ 0 & 0 & 1 & 0 & 0 & 0 \\ 1 & 0 & 0 & 0 & 1 & 0 \\ 0 & 1 & 0 & -1 & 0 & 0 \\ 0 & 0 & 0 & 0 & 0 & 1 \end{bmatrix},$$

the third whole signal set $\underline{x}_{+\text{-}0}(t)$ can be denoted as:

$$\underline{x}_{+\text{-}0}(t) = \begin{bmatrix} x_\alpha^+(t) \\ x_\beta^+(t) \\ x_0(t) \\ x_\alpha^-(t) \\ x_\beta^-(t) \\ x_0(t-\tau) \end{bmatrix},$$

and

$x_\alpha^+(t)$ is the positive-sequence component of the first α-axis component, $x_\beta^+(t)$ is the positive-sequence component of the first β-axis component, $x_0(t)$ is first zero-sequence component, $x_\alpha^-(t)$ is the negative-sequence component of the first α-axis component, $x_\beta^-(t)$ is the negative-sequence component of the first β-axis component, and $x_0(t-\tau)$ is the second zero-sequence component.

According to some embodiments, because the positive-sequence d-axis component and a positive-sequence q-axis component are generated by performed the first Park transformation on the positive-sequence components, the negative-sequence d-axis component and the negative-sequence q-axis component are generated by performing the second Park transformation on the negative-sequence components, wherein the angle of the first Park transformation is the angle of the three-phases electrical signals, and the angle of the second Park transformation is a negative value of the angle of the first Park transformation, the positive-sequence d-axis component, the positive-sequence q-axis component, the negative-sequence d-axis component and the negative-sequence q-axis component are time-invariant.

According to some embodiments, performing a first Park transformation on the positive-sequence components to generate a positive-sequence d-axis component and a positive-sequence q-axis component, and performing a second Park transformation on the negative-sequence components to generate a negative-sequence d-axis component and a negative-sequence q-axis component (for example, step S304 in Fig. 3) can be performed by multiplying a first signal subset $x_1^{+-}(t)$ of the third whole signal set $\underline{x}_{+\text{-}0}(t)$ with a third transformation matrix $T_3$ to generate a first intermediate signal set $x_{dq}^{+-}(t)$, wherein the first signal subset $x_1^{+-}(t)$ includes the positive-sequence components and the negative-sequence components of the first transformed set.

For example, $T_3$ can be denoted as:

$$T_3 = \begin{bmatrix} T_{park}(\hat{\theta}) & 0_{2\times2} \\ 0_{2\times2} & T_{park}(-\hat{\theta}) \end{bmatrix},$$

the first intermediate signal set $x_{dq}^{+-}(t)$ can be denoted as:

$$x_{dq}^{+-}(t) = \begin{bmatrix} x_d^+(t) \\ x_q^+(t) \\ x_d^-(t) \\ x_q^-(t) \end{bmatrix},$$

and $\hat{\theta}$ is the angle of the three-phases electrical signals of the first signal set, $x_d^+(t)$ is the positive-sequence d-axis component, $x_q^+(t)$ is the positive-sequence q-axis component, $x_d^-(t)$ is the negative-sequence d-axis component, and $x_q^-(t)$ is the negative-sequence q-axis component.

According to some embodiments, performing a first Park transformation on the positive-sequence components to generate a positive-sequence d-axis component and a positive-sequence q-axis component, and performing a second Park transformation on the negative-sequence components to generate a negative-sequence d-axis component and a negative-sequence q-axis component (for example, step S304 in Fig. 3) can be performed by multiplying the third whole signal set $\underline{x}_{+-0}(t)$ with a third transformation matrix $T_3'$ to generate a fourth whole signal set $x_{dq0}^{+-}(t)$.

For example, $T_3'$ can be denoted as $T_3' = \begin{bmatrix} T_{park}'(\hat{\theta}) & 0_{3\times3} \\ 0_{3\times3} & T_{park}'(-\hat{\theta}) \end{bmatrix}$, wherein $T_{park}'(\theta)$ can be

denoted as $T_{park}'(\theta) = \begin{bmatrix} T_{park}(\theta) & 0 \\ 0_{2\times1} & 1 \end{bmatrix}$, $\hat{\theta}$ is the angle of the three-phases electrical signals of the first signal set,

$$x_{dq0}^{+-}(t) = \begin{bmatrix} X_d^+ \\ X_q^+ \\ x_0(t) \\ X_d^- \\ X_q^- \\ x_0(t-\tau) \end{bmatrix},$$

and the fourth whole signal set $x_{dq0}^{+-}(t)$ can be denoted as: wherein $X_d^+$ is the positive-sequence d-axis component, $X_q^+$ is the positive-sequence q-axis component, $x_0(t)$ is first zero-sequence component, $X_d^-$ is the negative-sequence d-axis component, and $X_q^-$ is the negative-sequence q-axis component, and $x_0(t-\tau)$ is the second zero-sequence component, and

if the three-phases electrical signals of the first signals set $x_{abc}(t)$ are denoted as $x_{abc}(t) = \begin{bmatrix} X_a cos\theta_a(t) \\ X_b cos\theta_b(t) \\ X_c cos\theta_c(t) \end{bmatrix}$, the time shift between one signal of the first signal set and the corresponding signal of the second signal set is T/4, and steps S302-S304 in Fig. 3 are performed as defined above with reference to matrices $T_1$, $T_2$ and $T_3'$ or $T_1$, $T_2$ and $T_3'$, the positive-sequence d-axis component Xd is $\frac{1}{3}(X_a + X_b + X_c)$, the positive-sequence q-axis component $X_q^+$ is 0, the negative-sequence d-axis component $X_d^-$ is $(2X_a - X_b - X_c)$, and the negative-sequence q-axis component $X_q^-$ is $\frac{\sqrt{3}}{6}(X_c - X_b)$.

According to some embodiments, because the zero-sequence d-axis component and the zero-sequence q-axis component are generated by performing the first Park transformation on the first zero-sequence component and the second zero-sequence component, the zero-sequence d-axis component and the zero-sequence q-axis component are time-invariant.

According to some embodiments, performing the first Park transformation on the first zero-sequence component and the second zero-sequence component to generate a zero-sequence d-axis component and a zero-sequence q-axis component (for example, step S305 in Fig. 3) can be performed by multiplying a second signal subset $x_2^{+-}(t)$ of the third whole signal set $\underline{x}_{+-0}(t)$ with a fourth transformation matrix $T_4$ to generate a second intermediate signal set $x_{dq}^0(t)$, wherein the second signal subset $x_2^{+-}(t)$ includes the first zero-sequence component and the second zero-sequence component. For example, $T_4$ can be denoted as $T_4 = [T_{park}(\hat{\theta})]$, the second intermediate signal set $x_0^{+-}(t)$ can be denoted as $x_{dq}^0(t) = \begin{bmatrix} X_d^0 \\ X_q^0 \end{bmatrix}$, and $\hat{\theta}$ is the angle of the three-phases electrical signals of the first signal set, Xd is the zero-sequence d-axis component, Xq is the zero-sequence q-axis component.

According to some embodiments, performing the first Park transformation on the first zero-sequence component and the second zero-sequence component to generate a zero-sequence d-axis component and a zero-sequence q-axis component (for example, step S305 in Fig. 3) can be performed by multiplying the fourth whole signal set with a fourth transformation matrix $T_4'$ and a fifth matrix $T_5$ to generate a fifth whole signal set $x_{dq}^{+-0}(t)$.

$$T_4 = \begin{bmatrix} 1 & 0 & 0 & 0 & 0 & 0 \\ 0 & 0 & 0 & 1 & 0 & 0 \\ 0 & 0 & 0 & 0 & 1 & 0 \\ 0 & 0 & 1 & 0 & 0 & 0 \\ 0 & 0 & 0 & 0 & 0 & 1 \\ 0 & 1 & 0 & 0 & 0 & 0 \end{bmatrix}$$

For example, $T_4$ can be denoted as the above, and $T_5$ can be denoted as $T_5 = \begin{bmatrix} I_{3\times3} & 0_{3\times3} \\ 0_{3\times3} & T_{park}'(\hat{\theta}) \end{bmatrix}$, wherein $T_{park}'(\theta)$ can be denoted as $T_{park}'(\theta) = \begin{bmatrix} T_{park}(\theta) & 0 \\ 0_{2\times1} & 1 \end{bmatrix}$, $\hat{\theta}$ is the angle of the three-phases electrical signals of the first signal set, and the fifth whole signal set $x_{dq}^{+-0}$ can be denoted as:

$$x_{dq0}^{+-} = \begin{bmatrix} X_d^+ \\ X_d^- \\ X_q^- \\ X_d^0 \\ X_q^0 \\ X_q^+ \end{bmatrix}$$, wherein $X_d^+$ is the positive-sequence d-axis component, $X_q^+$ is the positive-sequence q-axis component, $X_d^0$ is the zero-sequence d-axis component, $X_d^-$ is the negative-sequence d-axis component, and $X_q^-$ is the negative-sequence q-axis component, and Xq is the zero-sequence q-axis component.

According to some embodiments, the three-phases electrical signals of the first signal set are magnitude-imbalanced and/or phase-imbalanced. According to some embodiments, the "magnitude-imbalanced" means that the magnitudes of the three-phases electrical signals are not equal. According to some embodiments, the "phase-imbalanced" means that the three phases of the three-phases electrical signals are not evenly spaced apart from each other, i.e., the phase angles between the three-phases electrical signals are not all equal to 120 degrees.

For example, in the situation of merely magnitude-imbalanced, if the three-phases electrical signals of the first

$$x_{abc}(t) = \begin{bmatrix} X_a \cos\theta_a(t) \\ X_b \cos\theta_b(t) \\ X_c \cos\theta_c(t) \end{bmatrix}$$

signals set $x_{abc}(t)$ are denoted as , wherein $X_a$, $X_b$ and $X_c$ are the magnitudes of the three-phases electrical signals of the first signal set, the angles of the three-phases electrical signals are denoted as

$$\begin{bmatrix} \theta_a(t) \\ \theta_b(t) \\ \theta_c(t) \end{bmatrix} = \begin{bmatrix} \varpi t \\ \varpi t - 2\pi/3 \\ \varpi t + 2\pi/3 \end{bmatrix}$$

, $\varpi$ is the angular frequency of the three-phases electrical signals of the first signal set, t is time, T is the cycle of the three-phases electrical signals of the first signal set, the time shift between one signal of the first signal set and the corresponding signal of the second signal set is T/4, and steps S302, S303 and S305 in Fig. 3 are performed as defined above with reference to matrices $T_1$ - $T_2$ and $T_4$, or, $T_1$ - $T_2$, $T_4'$ and $T_5$, the zero-sequence d-axis component and the zero-sequence q-axis component are derived as follows:

1) For a set of sinusoids with an identical frequency and arbitrary magnitudes and phase shifts, the following proposition holds: $Y\cos(\varpi t + \phi) = \sum_{j=1}^{n} Y_j \cos(\varpi t + \phi_j)$ , wherein n is a positive integer and Y and $\phi$ are given by $Y = \sqrt{\left(\sum_{j=1}^{n} Y_j \cos\phi_j\right)^2 + \left(\sum_{j=1}^{n} Y_j \sin\phi_j\right)^2}$ and $\phi = \tan^{-1}\left(\frac{\sum_{j=1}^{n} Y_j \sin\phi_j}{\sum_{j=1}^{n} Y_j \cos\phi_j}\right)$ ;

2) By applying the above-mentioned proposition, the first zero-sequence component $x_0(t)$ and the second zero-sequence component $x_0(t - \tau)$ can be derived as $k_0 X_0 \cos(\varpi t + \phi_0)$ and $k_0 X_0 \sin(\varpi t + \phi_0)$ , wherein $k_0 = 1/6$, and $X_0$ and $\phi_0$ are time-irrelevant values defined according to the above-mentioned proposition with $Y_j \in \{X_a, X_b, X_c\}$ and $\phi_j \in \{0, \pm 2\pi/3\}$;

3) By performing the first Park transformation on the first zero-sequence component and the second zero-sequence component to generate a zero-sequence d-axis component and a zero-sequence q-axis component as above mentioned, the zero-sequence d-axis component is derived as $k_0 \cos(\phi)_0 X_0$, and the zero-sequence q-axis component is derived as $k_0 \sin(\phi_0) X_0$, and it can be seen that both the zero-sequence d-axis component and the zero-sequence q-axis component are time-irrelevant.

For example, in the situation of phase-imbalance (either merely phase-imbalance or phase- and-magnitude-imbalance), the three-phases electrical signals of the first signals set $x_{abc}(t)$ are denoted as

$$x_{abc}(t) = \begin{bmatrix} X_a \cos(\theta_a(t) + \delta_a) \\ X_b \cos(\theta_b(t) + \delta_b) \\ X_c \cos(\theta_c(t) + \delta_c) \end{bmatrix}$$

, wherein $X_a$, $X_b$ and $X_c$ are the magnitudes of the three-phases electrical signals of the first signal set, $\delta_a$, $\delta_b$ and $\delta_c$ are the extra phase shifts of the three-phases electrical signals of the first signal

$$\begin{bmatrix} \theta_a(t) \\ \theta_b(t) \\ \theta_c(t) \end{bmatrix} = \begin{bmatrix} \varpi t \\ \varpi t - 2\pi/3 \\ \varpi t + 2\pi/3 \end{bmatrix}$$

set, , $\varpi$ is the angular frequency of the three-phases electrical signals of the first signal set, t is time, the three-phases electrical signals of the first signals set $x_{abc}(t)$ can derived as follows:

1) By expanding the three-phases electrical signals of the first signals set $x_{abc}(t)$, the three-phases electrical signals of the first signals set $x_{abc}(t)$ be derived as

$$x_{abc}(t) = \begin{bmatrix} X_a\cos(\theta_a(t)+\delta_a) \\ X_b\cos(\theta_b(t)+\delta_b) \\ X_c\cos(\theta_c(t)+\delta_c) \end{bmatrix} = \begin{bmatrix} X_a(\cos\theta_a(t)\cos\delta_a - \sin\theta_a(t)\sin\delta_a) \\ X_b(\cos\theta_b(t)\cos\delta_b - \sin\theta_b(t)\sin\delta_b) \\ X_c(\cos\theta_c(t)\cos\delta_c - \sin\theta_c(t)\sin\delta_c) \end{bmatrix}$$

$$= \begin{bmatrix} \widetilde{X}_a\cos\theta_a(t) \\ \widetilde{X}_b\cos\theta_b(t) \\ \widetilde{X}_c\cos\theta_c(t) \end{bmatrix} - \begin{bmatrix} \widehat{X}_a\sin\theta_a(t) \\ \widehat{X}_b\sin\theta_b(t) \\ \widehat{X}_c\sin\theta_c(t) \end{bmatrix}, \text{ wherein } \begin{bmatrix} \widetilde{X}_a \\ \widetilde{X}_b \\ \widetilde{X}_c \end{bmatrix} = \begin{bmatrix} X_a\cos\delta_a \\ X_b\cos\delta_b \\ X_c\cos\delta_c \end{bmatrix}, \text{ and } \begin{bmatrix} \widehat{X}_a \\ \widehat{X}_b \\ \widehat{X}_c \end{bmatrix} = \begin{bmatrix} X_a\sin\delta_a \\ X_b\sin\delta_b \\ X_c\sin\delta_c \end{bmatrix};$$

2) By shifting the angle as $\begin{bmatrix} v_a(t) \\ v_b(t) \\ v_c(t) \end{bmatrix} = \begin{bmatrix} \theta_a(t) \\ \theta_b(t) \\ \theta_c(t) \end{bmatrix} - \begin{bmatrix} \pi/2 \\ \pi/2 \\ \pi/2 \end{bmatrix}$, the above sine term $\begin{bmatrix} \widehat{X}_a\sin\theta_a(t) \\ \widehat{X}_b\sin\theta_b(t) \\ \widehat{X}_c\sin\theta_c(t) \end{bmatrix}$ can be written

as $\begin{bmatrix} \widehat{X}_a\cos v_a(t) \\ \widehat{X}_b\cos v_b(t) \\ \widehat{X}_c\cos v_c(t) \end{bmatrix}$, and $x_{abc}(t) = \begin{bmatrix} \widetilde{X}_a\cos\theta_a(t) \\ \widetilde{X}_b\cos\theta_b(t) \\ \widetilde{X}_c\cos\theta_c(t) \end{bmatrix} - \begin{bmatrix} \widehat{X}_a\cos v_a(t) \\ \widehat{X}_b\cos v_b(t) \\ \widehat{X}_c\cos v_c(t) \end{bmatrix}$, i.e., transforming the imbalanced three-phases electrical signals into two phase-balanced terms $\begin{bmatrix} \widetilde{X}_a\cos\theta_a(t) \\ \widetilde{X}_b\cos\theta_b(t) \\ \widetilde{X}_c\cos\theta_c(t) \end{bmatrix}$ and $\begin{bmatrix} \widehat{X}_a\cos v_a(t) \\ \widehat{X}_b\cos v_b(t) \\ \widehat{X}_c\cos v_c(t) \end{bmatrix}$. In this
case, it can be seen that the above mentioned generalized-dq0 transformation can be performed on each term of $x_{abc}$

(t) (i.e., $\begin{bmatrix} \widetilde{X}_a\cos\theta_a(t) \\ \widetilde{X}_b\cos\theta_b(t) \\ \widetilde{X}_c\cos\theta_c(t) \end{bmatrix}$ or $\begin{bmatrix} \widehat{X}_a\cos v_a(t) \\ \widehat{X}_b\cos v_b(t) \\ \widehat{X}_c\cos v_c(t) \end{bmatrix}$) separately. Therefore, by applying the above mentioned first signal
transformation (i.e., the generalized dq0 transformation), the phase-imbalanced three phases signals including two
phase-balance terms can be transformed to a set of time-irrelevant quantities.

According to some embodiments, the above mentioned method for controlling a power converter can be applied in the Phase-Locked- Loop (PLL) application, which usually refers to the cases in which the transformation is used to estimate/measure the frequency and phase information of the three-phase electrical signals (especially in the imbalanced conditions), wherein such information is then typically used to synchronize the converter with the grid or design low-level controllers in synchronous coordinate frames. According to some embodiments, the PLL application can be LV, MV, FACTS, HVDC, and parallel-connected converters, phasor measurement unit (PMU), microgrid controllers, and power system state estimation algorithms.

According to some embodiments, the abovementioned method for controlling a power converter can be applied in the non-PLL application, which usually refers to refers to the case in which the transformation is used to either measure, process, or monitor three-phase electrical signals (especially in the imbalanced conditions). According to some embodiments, the non-PLL application can be monitoring systems for transformers, motors, drive systems, generators, synchronous condensers.

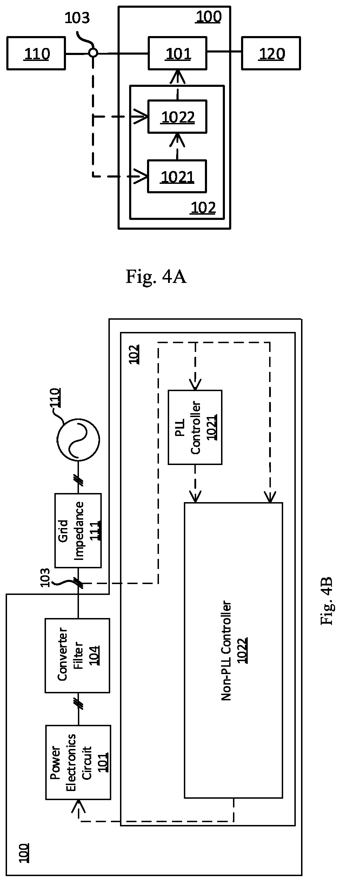

Fig. 4A is a schematic diagram illustrating the controller for the power converter 102 according to some embodiments of the present disclosure.

According to some embodiments, the difference between Figs. 1 and Fig. 4A is that the controller 102 includes a PLL controller 1021 and a non-PLL controller 1022.

According to some embodiments, the "PLL controller" refers to a controller that is used to synchronize the phase of an output signal with the phase of an input reference signal. According to some embodiments, the "non-PLL controller" refers a controller that is not PLL controller.

According to some embodiments, the PLL controller 1021 receives the three-phases electrical signals (for example, the three-phases phase voltage, the three-phases line voltage, the three-phases phase current and/or the three-phases line current) to output the frequency and/or the angle of the three-phases electrical signals to the non-PLL controller 1022.

According to some embodiments, the non-PLL controller 1022 receives the frequency and/or the angle of the three-phases electrical signals from the PLL controller 1021 and the three-phases electrical signals, and generate the control signal for the components of the power electronics circuit 101, e.g., the power switch and/or the protection device (e.g., the breaker, the relay, etc.).

Fig. 4B is a schematic diagram illustrating the controller for the power converter 102 according to some embodiments of the present disclosure.

According to some embodiments, the difference between Figs. 4A and 4B is: (1) the power converter 100 also includes a converter filter 104 between the power electronics circuit 101 and the port 103; and (2) there exists a grid impedance 111 between the port 103 and the three-phases source/load 110.

According to some embodiments, the non-PLL controller 1022 may be the grid-forming controller, the grid-following controller or the unified forming-following controller.

For the purpose of illustration, the load/source 120 is omitted in Fig. 4B, but it should be understood that that there exists the load/source coupled to the power electronics circuit 101 at another port other than the port 103.

According to some embodiments, the controlling the power converter according to the at least one first intermediate signal comprises: generating a control signal for the converter based on the at least one first intermediate signal by a control loop of the power converter, wherein the control loop comprises at least one of a PLL loop, an active power control loop, a reactive power control loop, a virtual impedance loop, a virtual admittance loop, a current control loop and a voltage control loop; and controlling the converter according to the generated control signal. According to some embodiments, the above-mentioned generalized dq0 transformation can be applied to different applications in the control of power converter.

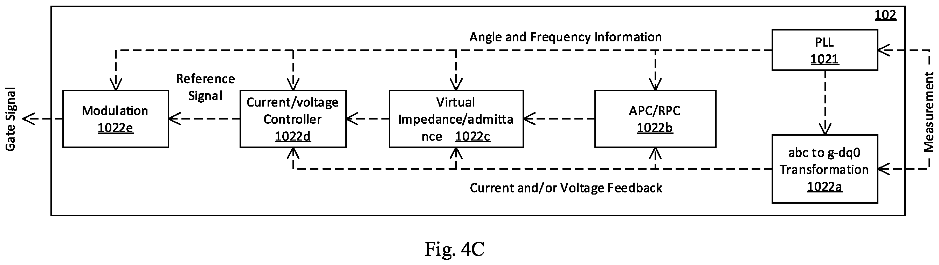

Fig. 4C is a schematic diagram illustrating the controller for the power converter 102 according to some embodiments of the present disclosure.

According to some embodiments, the controller 102 includes a PLL controller 1021, an abc to g-dq0 transformation block 1022a, an active power control and/or reactive power control (APC/RPC) controller 1022b, a virtual impedance and/or admittance controller 1022c, a current and/or voltage controller 1022d and a modulation block 1022e.

According to some embodiments, the PLL controller 1021 includes the PLL loop, the APC/RPC controller 1022b includes the active power control loop and/or the reactive power control loop, the virtual impedance and/or admittance controller 1022c includes the virtual impedance loop and/or the virtual admittance loop, and the current and/or voltage controller 1022d includes a current control loop and/or a voltage control loop.

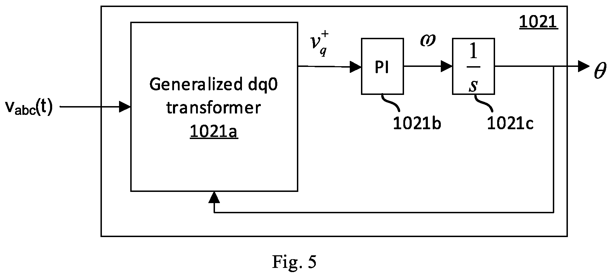

According to some embodiments, the PLL controller 1021 receives the measurement of the three-phases electrical signals, wherein the PLL controller 1021 outputs the angle and/or frequency of the three-phases electrical signals to the abc to g-dq0 transformation block 1022a, the active power control and/or reactive power control (APC/RPC) controller 1022b, the virtual impedance and/or admittance controller 1022c, the current and/or voltage controller 1022d and the modulation block 1022e. According to some embodiments, the generalized dq0 transformation (g-dq0) described with reference to Fig. 3 is implemented in PLL controller 1021, which will be further discussed with reference to Fig. 5.

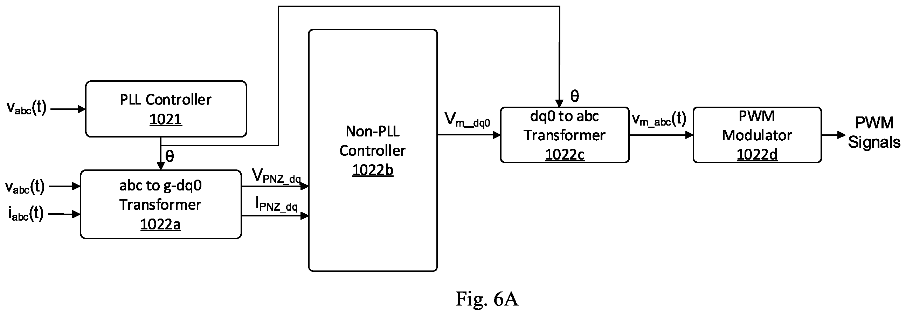

According to some embodiments, the abc to g-dq0 transformation block 1022a converts the measured three-phases electrical signals of phases a, b and c into the at least least one intermediate signal by the generalized dq0 transformation (g-dq0) described with reference to Fig. 3 and implemented in PLL controller 1021, which will be further discussed with reference to Figs. 6A-6B.

According to some embodiments, the at least one intermediate signal generated by the abc to g-dq0 transformation block 1022a can provided to the active power control and/or reactive power control (APC/RPC) controller 1022b, the virtual impedance and/or admittance controller 1022c and the current and/or voltage control controller 1022d as the current and/or voltage feedback to generate the reference signal for the modulation block 1022e.

According to some embodiments, as shown in Fig. 4C, the modulation block 1022e can generate the gate signal for the power switch of the power electronics circuit based on the reference signal and the angle and/or frequency of the three-phases electrical signals. According to some embodiments, although not shown in Fig.4C, the controller 102 may also include protection controller, which generates the protection signal for the protection device of the power electronics circuit based on the angle and/or frequency of the three-phases electrical signals from the PLL controller 1021 and/or the current and/or voltage feedback from the abc to g-dq0 transformation block 1022a.

According to some embodiments, the control loop comprises a PLL loop, wherein the PLL loop comprises a PI module and an integration module connected in series, and, the control signal comprises an angle signal, the generating a control signal for the converter based on the at least one first intermediate signal by a control loop of the power converter comprises: inputting to the at least one first intermediate signal into the PI module; and generating the angle signal at the output of the integration module, wherein the angle of the first Park transformation and the second Park transformation is determined based on the angle signal. According to some embodiments, as the generalized dq0 transformation is used in the PLL loop, the PLL loop does not rely on lowpass filtering, averaging methods, or approximate cancellation techniques that are conventionally used for the three phases imbalance, and it can achieve faster synchronization timescales.

Fig. 5 is a schematic diagram illustrating a PLL controller 1021 of the controller for the power converter in Figs. 4A-4C according to some embodiments of the present disclosure.

According to some embodiments, the PLL controller 1021 includes a generalized dq0 transformer 1021a and a PLL loop comprising a PI module 1021b and an integration module 1021c connected in series.

According to some embodiments, the three-phases electrical signals (for example, three-phases voltage signals $v_{abc}(t)$ as shown in Fig. 5) are input to the generalized dq0 transformer 1021a, which performs the generalized dq0 transformation described with reference to Fig. 3.

According to some embodiments, the generalized dq0 transformer 1021a outputs one intermediate signal (for example, $v_q^+$ ) to the PLL loop for phase lock, wherein the intermediate signal is input to the PI module 1021b to generate an angular velocity signal ω, and the angular velocity signal ω is input into the integration module 1021c to generate an angle signal θ.

According to some embodiments, the angle signal θ is provided as feedback to the generalized dq0 transformer 1021a, wherein the angle of the first Park transformation and the second Park transformation in the generalized dq0 transformation performed by the generalized dq0 transformer 1021a is determined based on the angle signal θ.

According to some embodiments, the control loop comprises a non-PLL loop, and the generating a control signal for the converter based on the at least one first intermediate signal by a control loop of the power converter comprises: determining an error signal based on the at least one first intermediate signal and a reference signal; and generating the control signal based on the error signal. According to some embodiments, as the generalized dq0 transformation is used in the non-PLL loop, the intermediate signal irrelevant to the time can be provided, which simplifies the corresponding control mechanism.

Figs. 6A-6B are schematic diagrams illustrating a non-PLL loop of the controller for the power converter in Figs. 4A-4C according to some embodiments of the present disclosure.

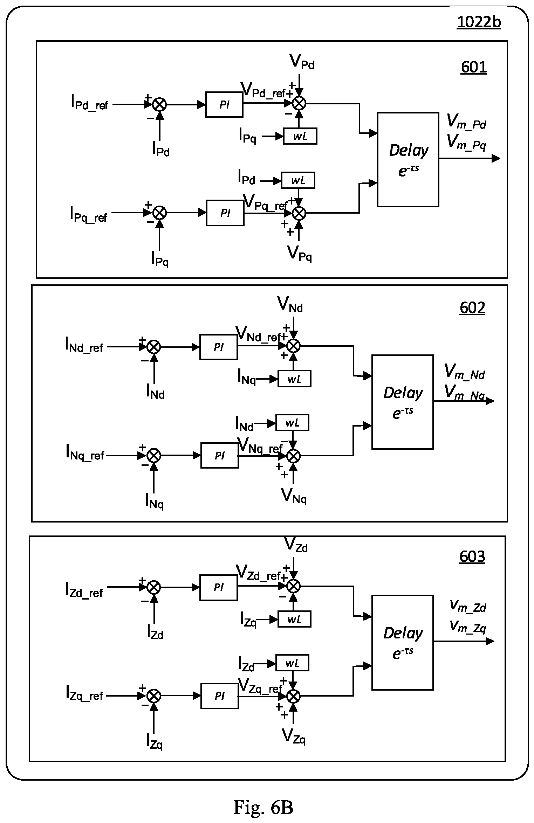

In particular, Fig. 6A is a schematic diagram illustrating a non-PLL controller 1022b including a non-PLL loop, and Fig. 6B is a schematic diagram illustrating the exemplary non-PLL loop of the non-PLL controller 1022b.

As shown in Fig. 6A, the PLL controller 1021 (for example, the PLL controller 1021 in Figs. 4A-4C and 5) receives the first three-phases electrical signals $v_{abc}(t)$ and generates an angle signal θ; the abc-to g-dq0 transformer 1022a (for example, the g-dq0 transformation block 1022a in Fig. 4C) receives the first three-phases electrical signals $v_{abc}(t)$, the second three-phases electrical signals $i_{abc}(t)$ and the angle signal θ, and transforms the first three-phases electrical signals $v_{abc}(t)$ and the second three-phases electrical signals $i_{abc}(t)$ into a first intermediate signal set $V_{PNZ\_dq}$ and a second intermediate signal set $I_{PNZ\_dq}$; the non-PLL controller 1022b receives the first intermediate signal set $V_{PNZ\_dq}$ and the second intermediate signal set $I_{PNZ\_dq}$, and generates the first modulation signal set $V_{m\_dq0}$; the dq0 to abc transformer 1022c receives the first modulation signal set $V_{m\_dq0}$ and the angle signal θ, and transforms the first modulation signal set $V_{m\_dq0}$ to the second modulation signal set $V_{m\_abc}(t)$ in the phases a, b and c; and the PWM modulator 1022d modulates the PWM signals based on the second modulation signal set $V_{m\_abc}(t)$.

According to some embodiments, based on the abc-to g-dq0 transformer 1022a, the time-variant first and second three-phases electrical signals $v_{abc}(t)$ and $i_{abc}(t)$ can be transformed to the time-invariant first and second intermediate signal sets $V_{PNZ\_dq}$ and $I_{PNZ\_dq}$, thereby simplifying the control structure of the non-PLL controller 1022b. According to some embodiments, the dq0 to abc transformer 1022c transforms the first modulation signal set $V_{m\_dq0}$ to the second modulation signal set $V_{m\_abc}(t)$ in the phases a, b and c, thereby facilitating the controlling of the power switches of three-phases in the power electronics circuit.

As shown in Fig. 6B, the non-PLL controller 1022b includes non-PLL loop, which includes three sub-loops including the positive-sequence sub-loop 601, the negative-sequence sub-loop 602 and the zero-sequence sub-loop 603.

According to some embodiments, the positive-sequence components of the first intermediate signal set $V_{PNZ\_dq}$ (i.e., the positive-sequence d-axis component $V_{Pd}$ and the positive-sequence q-axis component $V_{Pq}$) and the positive-sequence components of the second intermediate signal set $I_{PNZ\_dq}$ (i.e., the positive-sequence d-axis component $I_{Pd}$ and the positive-sequence q-axis component $I_{Pq}$) are input into the positive-sequence sub-loop 601 as the feedback, and are used to generate the error signals with reference to the corresponding reference signals, wherein the positive-sequence control signals $V_{m\_Pd}$ and $V_{m\_Pq}$ can be further generated based on the error signals.

According to some embodiments, the reference signal of the positive-sequence sub-loop 601 can be the given reference signal, such as the positive-sequence d-axis current reference $I_{Pd\_ref}$ and the positive-sequence q-axis current reference $I_{Pq\_ref}$; or, the reference signal of the positive-sequence sub-loop 601 can be the signal generated by the outer loop, such as the positive-sequence d-axis voltage reference $V_{Pd\_ref}$ and the positive-sequence q-axis voltage reference $V_{Pq\_ref}$.

According to some embodiments, the negative-sequence components of the first intermediate signal set $V_{PNZ\_dq}$ (i.e., the negative-sequence d-axis component $V_{Nd}$ and the negative-sequence q-axis component $V_{Nq}$) and the negative-sequence components of the second intermediate signal set $I_{PNZ\_dq}$ (i.e., the negative-sequence d-axis component $I_{Nd}$ and the negative-sequence q-axis component $I_{Nq}$) are input into the negative-sequence sub-loop 602 as the feedback, and are used to generate the error signals with reference to the corresponding reference signals, wherein the negative-sequence control signals $V_{m\_Nd}$ and $V_{m\_Nq}$ can be further generated based on the error signals.

According to some embodiments, the reference signal of the negative-sequence sub-loop 601 can be the given reference signal, such as the negative-sequence d-axis current reference $I_{Nd\_ref}$ and the negative-sequence q-axis current reference $I_{Nq\_ref}$; or, the reference signal of the negative-sequence sub-loop 601 can be the signal generated by the outer loop, such as the negative-sequence d-axis voltage reference $V_{Nd\_ref}$ and the negative-sequence q-axis voltage reference $V_{Nq\_ref}$.

According to some embodiments, the zero-sequence components of the first intermediate signal set $V_{PNZ\_dq}$ (i.e., the zero-sequence d-axis component $V_{Zd}$ and the zero-sequence q-axis component $V_{Zq}$) and the zero components of the second intermediate signal set $I_{PNZ\_dq}$ (i.e., the zero-sequence d-axis component $I_{Zd}$ and the zero-sequence q-axis component $I_{Zq}$) are input into the zero-sequence sub-loop 601 as the feedback, and are used to generate the error signals with reference to the corresponding reference signals, wherein the zero-sequence control signals can be further generated based on the error signals.

According to some embodiments, the reference signal of the zero-sequence sub-loop 601 can be the given reference signal, such as the zero-sequence d-axis current reference $I_{Zd\_ref}$ and the zero-sequence q-axis current reference $I_{Zq\_ref}$; or, the reference signal of the zero-sequence sub-loop 601 can be the signal generated by the outer loop, such as the zero-sequence d-axis voltage reference $V_{Zd\_ref}$ and the zero-sequence q-axis voltage reference $V_{Zq\_ref}$.

According to some embodiments, the controlling the power converter according to the at least one first intermediate signal comprises: generating an angle signal based on the at least one first intermediate signal by a PLL loop of the power converter; generating at least one second intermediate signal based on the angle signal by a non-PLL loop of the power converter, wherein a second signal transformation different from the first signal transformation is used in the non-PLL loop; and controlling the power converter according to the at least one second intermediate signal. According to some embodiments, as the generalized dq0 transformation is used in the PLL loop, and the different signal transformation is used in at least one non-PLL loop, a flexible control structure can be provided.

According to some embodiments, the controlling the power converter according to the at least one first intermediate signal comprises: generating an angle signal by a PLL loop of the power converter, wherein a second signal transformation different from the first signal transformation is used in the PLL loop; inputting the angle signal and the at least one first intermediate signal into a non-PLL loop of the power converter to generate at least one second intermediate signal; and controlling the power converter according to the at least one second intermediate signal. According to some embodiments, as the generalized dq0 transformation is used in at least one non-PLL loop, and the different signal transformation is used in the PLL loop, a flexible control structure can be provided.

According to some embodiments, the power converter comprises at least one power switch and/or protection device, and the controlling the power converter according to the at least one first intermediate signal comprises: controlling the at least one power switch and/or protection device according to the at least one first intermediate signal. According to some embodiments, different components of the power converter can be controlled based on the intermediate signal.

According to another aspect of the present disclosure, a controller for a power converter is provided, wherein the controller is configured to perform any of claims described in the present disclosure.

According to yet another aspect of the present disclosure, a power converter is provided, wherein the power converter comprises: at least one power switch and/or at least one protection device; and the controller described in the present disclosure.

According to yet another aspect of the present disclosure, a computer-readable storage medium is provided, wherein the computer-readable storage medium has computer-readable instructions stored thereon, and when the computer-readable instructions are executed by a processor, the processor performs any of claims described in the present disclosure.

According to yet another aspect of the present disclosure, a computer program product is provided, which, when executed by a computer, cause the computer to perform any of claims described in the present disclosure.

The technical effects of the method discussed above can be applied to the converter, the controller, the computer-readable storage medium and the computer program product, and are therefore omitted herein.

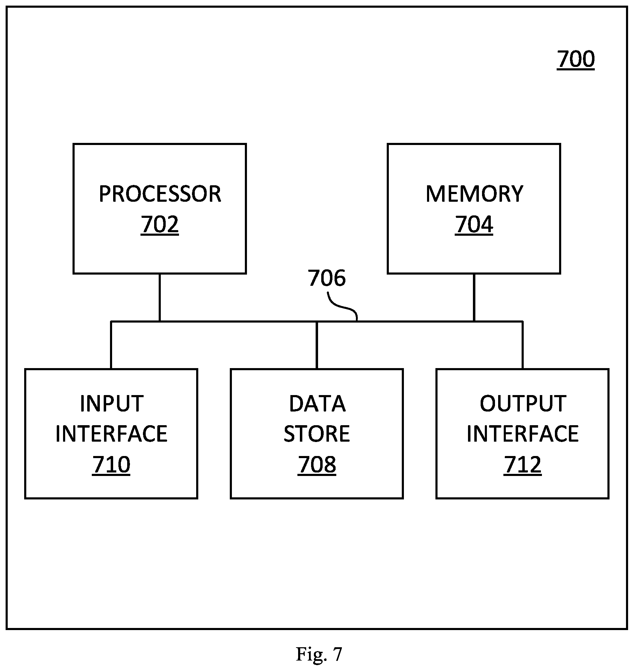

Referring now to FIG. 7, a high-level illustration of an exemplary computing device 700 that can be used in accordance with the methods disclosed herein is illustrated. The computing device 700 includes at least one processor 702 that executes instructions that are stored in a memory 704. The instructions may be, for instance, instructions for implementing functionality described as being carried out by one or more components discussed above or instructions for implementing one or more of the methods described above. The processor 702 may access the memory 704 by way of a system bus 706.

The computing device 700 additionally includes a data store 708 that is accessible by the processor 702 by way of the system bus 706. The data store 708 may include executable instructions, log data, etc. The computing device 700 also includes an input interface 710 that allows external devices to communicate with the computing device 700. For instance, the input interface 710 may be used to receive instructions from an external computer device, from a user, etc. The computing device 700 also includes an output interface 712 that interfaces the computing device 700 with one or more external devices. For example, the computing device 700 may display text, images, etc. by way of the output interface 712.

It is contemplated that the external devices that communicate with the computing device 700 via the input interface 710 and the output interface 712 can be included in an environment that provides substantially any type of user interface with which a user can interact. Examples of user interface types include graphical user interfaces, natural user interfaces, and so forth. For instance, a graphical user interface may accept input from a user employing input device(s) such as a keyboard, mouse, remote control, or the like and provide output on an output device such as a display. Further, a natural user interface may enable a user to interact with the computing device 700 in a manner free from constraints imposed by input device such as keyboards, mice, remote controls, and the like. Rather, a natural user interface can rely on speech recognition, touch and stylus recognition, gesture recognition both on screen and adjacent to the screen, air gestures, head and eye tracking, voice and speech, vision, touch, gestures, machine intelligence, and so forth.

Additionally, while illustrated as a single system, it is to be understood that the computing device 700 may be a distributed system. Thus, for instance, several devices may be in communication by way of a network connection and may collectively perform tasks described as being performed by the computing device 700.

Various functions described herein can be implemented in hardware, software, or any combination thereof. If implemented in software, the functions can be stored on or transmitted over as one or more instructions or code on a computer-readable medium. Computer-readable media includes computer-readable storage media. A computer-readable storage media can be any available storage media that can be accessed by a computer. By way of example, and not limitation, such computer-readable storage media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Disk and disc, as used herein, include compact disc (CD), laser disc, optical disc, digital versatile disc (DVD), floppy disk, and Blu-ray disc (BD), where disks usually reproduce data magnetically and discs usually reproduce data optically with lasers. Further, a propagated signal is not included within the scope of computer-readable storage media. Computer-readable media also includes communication media including any medium that facilitates transfer of a computer program from one place to another. A connection, for instance, can be a communication medium. For example, if the software is transmitted from a website, server, or other remote source using a coaxial cable, fibre optic cable, twisted pair, digital subscriber line (DSL), or wireless technologies such as infrared, radio, and microwave, then the coaxial cable, fibre optic cable, twisted pair, DSL, or wireless technologies such as infrared, radio and microwave are included in the definition of communication medium. Combinations of the above should also be included within the scope of computer-readable media. It should be understood that the computer program product can be stored on the non-transitory computer-readable storage medium or can be downloaded through the communication medium.

The flowcharts and block diagrams in the accompanying drawings illustrate the possibly implemented architecture, functions, and operations of the system, method, and computer program product according to various embodiments of the present disclosure. In this regard, each block in the flowchart or block diagram may represent a module, program segment, or part of code, and the module, program segment, or part of code contains one or more executable instructions for implementing the logical functions. It should also be noted that, in some alternative implementations, the functions marked in the blocks may also occur in an order different from that marked in the accompanying drawings. For example, two blocks shown in succession can actually be performed substantially in parallel, or they can sometimes be performed in the reverse order, depending on the functions involved. It should also be noted that each block in the block diagram and/or the flowchart, and a combination of the blocks in the block diagram and/or the flowchart may be implemented by a dedicated hardware-based system that executes functions or operations, or may be implemented by a combination of dedicated hardware and computer instructions.

The foregoing descriptions are merely preferred embodiments of the present disclosure and explanations of the applied technical principles. Those skilled in the art should understand that the scope of the present disclosure involved in the embodiments of the present disclosure is not limited to the technical solutions formed by specific combinations of the foregoing technical features, and shall also cover other technical solutions formed by any combination of the foregoing technical features or equivalent features thereof without departing from the foregoing inventive concept. For example, a technical solution formed by a replacement of the foregoing features with technical features with similar functions in the technical features disclosed in the embodiments of the present disclosure (but not limited thereto) also falls within the scope of the present disclosure.

**Claims**

**1.** A method (200) for controlling a power converter (100), comprising:

obtaining (S210) a first signal set comprising three-phases electrical signals at a port of the power converter;
performing (S220) a first signal transformation on the first signal set to generate at least one first intermediate signal, comprising:

generating (S301) a second signal set based on the first signal set, wherein a time shift between a signal of the first signal set and its corresponding signal of the second signal set is substantially T/4 or (-T/4), wherein T is a cycle of the three-phases electrical signals of the first signal set;

performing (S302) a Clarke transformation on the first signal set and the second signal set respectively to generate a first transformed set and a second transformed set, wherein the first transformed set comprises a first α-axis component, a first β-axis component and a first zero-sequence component, and the second transformed set comprises a second α-axis component, a second β-axis component and a second zero-sequence component;

extracting (S303) positive-sequence components and negative-sequence components of the first transformed set based on the first α-axis component, the first β-axis component, the second α-axis component and the second β-axis component, wherein the positive-sequence components of the first transformed set comprise a positive-sequence component of the first α-axis component and a positive-sequence component of the first β-axis component, and the negative-sequence components of the first transformed set comprises a negative-sequence component of the first α-axis component and a negative-sequence component of the first β-axis component;

performing (S304) a first Park transformation on the positive-sequence components to generate a positive-sequence d-axis component and a positive-sequence q-axis component, and performing a second Park transformation on the negative-sequence components to generate a negative-sequence d-axis component and a negative-sequence q-axis component, wherein an angle of the first Park transformation is the angle of the three-phases electrical signals of the first signal set, and an angle of the second Park transformation is a negative value of the angle of the first Park transformation; and

performing (S305) the first Park transformation on the first zero-sequence component and the second zero-sequence component to generate a zero-sequence d-axis component and a zero-sequence q-axis component,

wherein the at least one first intermediate signal comprises at least one of the positive-sequence d-axis component, the positive-sequence q-axis component, the negative-sequence d-axis component, the negative-sequence q-axis component, the zero-sequence d-axis component and the zero-sequence q-axis component; and

controlling (S230) the power converter according to the at least one first intermediate signal.

2. The method according to claim 1, wherein the three-phases electrical signals of the first signal set are three-phases phase voltage, three-phases line voltage, three-phases phase current or three-phases line current.

3. The method according to claim 1 or 2, wherein the generating (S301) a second signal set based on the first signal set comprises:

setting the second signal set according to historical data of the first signal set,
wherein the historical data of the first signal set is the data sampled before T/4 in case that the time shift between one signal of the first signal set and the corresponding signal of the second signal set is T/4, and
wherein the historical data of the first signal set is the data sampled before 3T/4 in case that the time shift between one signal of the first signal set and the corresponding signal of the second signal set is (-T/4).

4. The method according to claim 1 or 2, wherein the generating (S301) a second signal set based on the first signal set comprises:
setting the second signal set according to currently obtained data of the first signal set.

5. The method according to any of claims 1-4, wherein the controlling (S230) the power converter according to the at least one first intermediate signal comprises:

generating a control signal for the converter based on the at least one first intermediate signal by a control loop of the power converter, wherein the control loop comprises at least one of a Phase-Locked Loop (PLL) loop, an active power control loop, a reactive power control loop, a virtual impedance loop, a virtual admittance loop, a current control loop and a voltage control loop; and
controlling the converter according to the generated control signal.

6. The method according to claim 5, wherein the control loop comprises the PLL loop, wherein the PLL loop comprises a Proportion-Integration PI module and an integration module connected in series, and, the control signal comprises an angle signal,
the generating a control signal for the converter based on the at least one first intermediate signal by a control loop of the power converter comprises:

inputting to the at least one first intermediate signal into the PI module; and
generating the angle signal at the output of the integration module,
wherein the angle of the first Park transformation and the second Park transformation is determined based on the angle signal.

7. The method according to claim 5, wherein the control loop comprises a non-PLL loop, and
the generating a control signal for the converter based on the at least one first intermediate signal by a control loop of the power converter comprises:

determining an error signal based on the at least one first intermediate signal and a reference signal; and
generating the control signal based on the error signal.

8. The method according to any of claims 1-4, wherein the controlling (S230) the power converter according to the at least one first intermediate signal comprises:

generating an angle signal based on the at least one first intermediate signal by a PLL loop of the power converter;
generating at least one second intermediate signal based on the angle signal by a non-PLL loop of the power converter, wherein a second signal transformation different from the first signal transformation is used in the non-PLL loop; and
controlling the power converter according to the at least one second intermediate signal.

9. The method according to any of claims 1-4, wherein the controlling (S230) the power converter according to the at least one first intermediate signal comprises:

generating an angle signal by a PLL loop of the power converter, wherein a second signal transformation different from the first signal transformation is used in the PLL loop;
inputting the angle signal and the at least one first intermediate signal into a non-PLL loop of the power converter to generate at least one second intermediate signal; and
controlling the power converter according to the at least one second intermediate signal.

10. The method according to any of claims 1-9, wherein the power converter comprises at least one power switch and/or protection device, and
the controlling the power converter according to the at least one first intermediate signal comprises:
controlling the at least one power switch and/or protection device according to the at least one first intermediate signal.

11. The method according to any of claims 1-10, wherein the three-phases electrical signals of the first signal set are magnitude-imbalanced and/or phase-imbalanced.

12. A controller (102) for a power converter (100), wherein the controller (102) is configured to perform the method of any of claims 1-11.

13. A power converter (100) comprising:

at least one power switch and/or at least one protection device; and
the controller (102) according to claim 12.

14. A computer-readable storage medium having computer-readable instructions stored thereon, when the computer-readable instructions are executed by a processor, the processor performs the method of any of claims 1-11.

15. A computer program product comprising instructions which, when executed by a computer, cause the computer to perform the method of any of claims 1-11.

EP 4 614 794 A1

Fig. 1

OBTAINING A FIRST SIGNAL SET COMPRISING THREE-PHASES ELECTRICAL SIGNALS AT A PORT OF THE POWER CONVERTER — S210

PERFORMING A FIRST SIGNAL TRANSFORMATION ON THE FIRST SIGNAL SET TO GENERATE AT LEAST ONE FIRST INTERMEDIATE SIGNAL — S220

CONTROLLING THE POWER CONVERTER ACCORDING TO THE AT LEAST ONE FIRST INTERMEDIATE SIGNAL — S230

Fig. 2

S220

GENERATING A SECOND SIGNAL SET BASED ON THE FIRST SIGNAL SET — S301

PERFORMING A CLARK TRANSFORMATION ON THE FIRST SIGNAL SET AND THE SECOND SIGNAL SET RESPECTIVELY TO GENERATE A FIRST TRANSFORMED SET AND A SECOND TRANSFORMED SET — S302

EXTRACTING POSITIVE-SEQUENCE COMPONENTS AND NEGATIVE-SEQUENCE COMPONENTS OF THE FIRST TRANSFORMED SET BASED ON THE FIRST A-AXIS COMPONENT, THE FIRST B-AXIS COMPONENT, THE SECOND A-AXIS COMPONENT AND THE SECOND B-AXIS COMPONENT — S303

PERFORMING A FIRST PARK TRANSFORMATION ON THE POSITIVE-SEQUENCE COMPONENTS TO GENERATE A POSITIVE-SEQUENCE D-AXIS COMPONENT AND A POSITIVE-SEQUENCE Q-AXIS COMPONENT, AND PERFORMING A SECOND PARK TRANSFORMATION ON THE NEGATIVE-SEQUENCE COMPONENTS TO GENERATE A NEGATIVE-SEQUENCE D-AXIS COMPONENT AND A NEGATIVE-SEQUENCE Q-AXIS COMPONENT — S304

PERFORMING THE FIRST PARK TRANSFORMATION ON THE FIRST ZERO-SEQUENCE COMPONENT AND THE SECOND ZERO-SEQUENCE COMPONENT TO GENERATE A ZERO-SEQUENCE D-AXIS COMPONENT AND A ZERO-SEQUENCE Q-AXIS COMPONENT — S305

Fig. 3

Fig. 4A

Fig. 4B

Fig. 4C

Fig. 5

$v_{abc}(t) \rightarrow$ **PLL Controller** **1021**

$\theta$

$v_{abc}(t) \rightarrow$
$i_{abc}(t) \rightarrow$ **abc to g-dq0 Transformer** **1022a**

$V_{PNZ\_dq}$
$I_{PNZ\_dq}$

**Non-PLL Controller** **1022b**

$V_{m\_dq0}$

$\theta$

**dq0 to abc Transformer** **1022c**

$v_{m\_abc}(t)$

**PWM Modulator** **1022d**

**PWM Signals**

Fig. 6A

Fig. 6B

Fig. 7

| | Europäisches Patentamt |
|---|---|
| | European Patent Office |
| | Office européen des brevets |

# EUROPEAN SEARCH REPORT

**Application Number**

EP 24 16 1920

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MOHAMMED NABIL ET AL: "An Improved Grid Impedance Estimation Technique under Unbalanced Voltage Conditions", 2019 IEEE PES INNOVATIVE SMART GRID TECHNOLOGIES EUROPE (ISGT-EUROPE), IEEE, 29 September 2019 (2019-09-29), pages 1-5, XP033661385, DOI: 10.1109/ISGTEUROPE.2019.8905766 [retrieved on 2019-11-18] * Section II. THREE-PHASE THREE-WIRE INVERTER SYSTEMS UNDER UNBALANCED GRID VOLTAGE CONDITIONS; Section III. METHODOLOGY; Section IV. RESULTS AND DISCUSSION, Equations 1, 4, 5, 6, 14, 15; figures 1-4; table I * | 1-15 | INV. H02M7/5387 H02M7/5395 H02M1/00 H02M1/32 G01R19/165 |
| A | EP 0 322 518 A1 (MITSUBISHI ELECTRIC CORP [JP]) 5 July 1989 (1989-07-05) * page 4, lines 25-28; figures 1,2,4 * | 1-15 | |
| A | US 2019/245458 A1 (WANG ZITAO [US] ET AL) 8 August 2019 (2019-08-08) * paragraphs [0024], [0064], [0066]; figures 3,4 * | 1-15 | TECHNICAL FIELDS SEARCHED (IPC) H02M G01R |
| A | CN 115 792 329 A (UNIV HEFEI TECHNOLOGY ET AL.) 14 March 2023 (2023-03-14) * abstract; figures 3-7 * | 1-15 | |
| A | CN 106 645 944 A (NANJING ESTUN AUTOMATION TECH CO LTD) 10 May 2017 (2017-05-10) * abstract; figures 1-8 * | 1-15 | |

The present search report has been drawn up for all claims

| Place of search | Date of completion of the search | Examiner |
|---|---|---|
| The Hague | 5 August 2024 | Kanelis, Konstantin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 1920

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2024

| Patent document cited in search report | | Publication date | Patent family member(s) | | Publication date |
|---|---|---|---|---|---|
| EP 0322518 | A1 | 05-07-1989 | AU | 2282788 A | 29-06-1989 |
| | | | DE | 3871927 T2 | 03-12-1992 |
| | | | EP | 0322518 A1 | 05-07-1989 |
| | | | HK | 182395 A | 08-12-1995 |
| | | | JP | H01173877 A | 10-07-1989 |
| | | | JP | H06105266 B2 | 21-12-1994 |
| | | | KR | 890010655 A | 10-08-1989 |
| | | | US | 4885656 A | 05-12-1989 |
| US 2019245458 | A1 | 08-08-2019 | NONE | | |
| CN 115792329 | A | 14-03-2023 | NONE | | |
| CN 106645944 | A | 10-05-2017 | NONE | | |

EPO FORM P0459

For more details about this annex : see Official Journal of the European Patent Office, No. 12/82